# EUROPEAN PATENT APPLICATION

(11) **EP 2 124 516 A2**
(43) Date of publication of application: **25.11.2009**
(21) Application number: 08011374.9
(22) Date of filing: 23.06.2008
(51) Int. Cl.: H05K 5/02, G06F 1/16

(54) **Supporter for multimedia player**

(30) Priority: 23.05.2008 KR 20080006700
(71) Applicant: DVICO Inc., Sungnam-city Gyeonggi-do 463-782 (KR)
(72) Inventor: Kwon, Jae-Won, Sungnam-city Gyeonggi-do 463-782 (KR)
(74) Representative: Weber, Joachim

(57) **Abstract**

Provided is a supporter for a multimedia player, the supporter comprising: a housing including a support groove, a plurality of legs and a coupling structure for coupling the housing with the multimedia player, wherein the support groove has a through-hole on the top surface of the housing through which air blows and further has a step portion formed in the central portion of the housing, wherein the plurality of legs is formed in the lower end of the side surface of the housing, and wherein the coupling structure is formed in the upper end of the support groove extending in the side-to-side direction; a fan being packed by a fan housing which is coupled to the center of the housing; and a bottom plate having a plurality of suction holes and being coupled to the housing at the lower end of the fan. The air is introduced by rotation of the fan and is then discharged through the through-hole, thereby lowering the temperature of the multimedia player which is coupled to the supporter.

## Description

### BACKGROUND OF THE INVENTION

### 1. Field of the Invention

The present invention relates to a supporter for supporting a multimedia player, and more specifically, to a supporter for supporting a multimedia player which can view HD broadcasting, HD video, HD DVD, or blue-ray images.

### 2. Description of the Related Art

A multimedia player may reproduce a variety of views such as broadcasting, HD video, DVD, and blue-ray images. The multimedia player with a small body but without monitor is connected to a power supply through a USB port or outlet and reproduces moving images on a nearby PC monitor or TV set.

The multimedia player may reproduce moving images stored in an internal hard disk or external disk. Further, the multimedia player can be connected via internet to a far-away PC and then reproduce moving images stored in the PC. Further, the multimedia player may reproduce music files in addition to moving images.

The multimedia player should view moving images on a nearby monitor, e.g. TV. When the multimedia player minimizes its volume while maintaining performance, the multimedia player becomes more competitive.

However, the multimedia player generates a large amount of heat while reproducing moving images, which requiring a cooling unit. The cooling unit is disposed in the multimedia player, the volume of the multimedia player inevitably increases, thereby degrading the competitive power of the multimedia player. Further, there is a limit in designing the multimedia player such that the heat is cooled down in the multimedia player.

### SUMMARY OF THE INVENTION

An advantage of the present invention is that it provides a supporter which is used to support a multimedia player which can view HD broadcasting, HD video, HD DVD, or blue-ray images. The supporter includes a rotating fan which cools down heat generated from the multimedia player, thereby enhancing the durability of the multimedia player. Further, since the fan is formed in the supporter, the size of the multimedia player can be reduced.

According to an aspect of the invention, a supporter for a multimedia player comprises a housing 10 including a support groove 12, a plurality of legs 13 and a coupling structure for coupling the housing with the multimedia player 100, wherein the support groove 12 has a through-hole on the top surface of the housing 10 through which air blows and further has a step portion 11 formed in the central portion of the housing 10, wherein the plurality of legs 13 is formed in the lower end of the side surface of the housing 10, and wherein the coupling structure is formed in the upper end of the support groove 12 extending in the side-to-side direction; a fan 20 being packed by a fan housing 21 which is coupled to the center of the housing 10; and a bottom plate 30 having a plurality of suction holes 31 and being coupled to the housing 10 at the lower end of the fan 20. The air is introduced by rotation of the fan 20 and is then discharged through the through-hole, thereby lowering the temperature of the multimedia player 100 which is coupled to the supporter 90.

The coupling structure may include at least one L-shaped locking projections 41 so as to be coupled by sliding to coupling holes of the multimedia player 100, and the locking projections 41 have an elongated locking groove 66 formed thereon. Further, the coupling structure may include a stopper projection 42 which is formed in one side of the top surface of the support groove 12 and springs out due to an elastic force, thereby one-touch coupling between the multimedia player 100 and the supporter 90 is checked. Further, the through-hole provided on the top surface of the housing 10 may be formed so that ventilation plates 46 having a plurality of elongated and curved ventilation holes 45 formed therein are coupled to the housing 10. Further, a close packing 77 is attached to the upper or lower end of the step portion 11 of the support groove 12.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:
FIG. 1 is a plan and front view of a supporter for a multimedia player according to the invention;
FIG. 2 is an exploded perspective view of the supporter according to the invention;
FIG. 3 is a cross-sectional view of the supporter according to the invention;
FIG. 4 is a bottom view of the supporter according to the invention;
FIG. 5 is a perspective view of the supporter according to the invention, seen at various angles; and
FIG. 6 is a diagram showing a state where the multimedia player is coupled to the supporter according to the invention.

### DETAILED DESCRIPTION OF THE PREFERRED EMBODIMENTS

Reference will now be made in detail to the embodiments of the present general inventive concept, examples of which are illustrated in the accompanying drawings, wherein like reference numerals refer to the like elements throughout. The embodiments are described below in order to explain the present general inventive concept by referring to the figures.

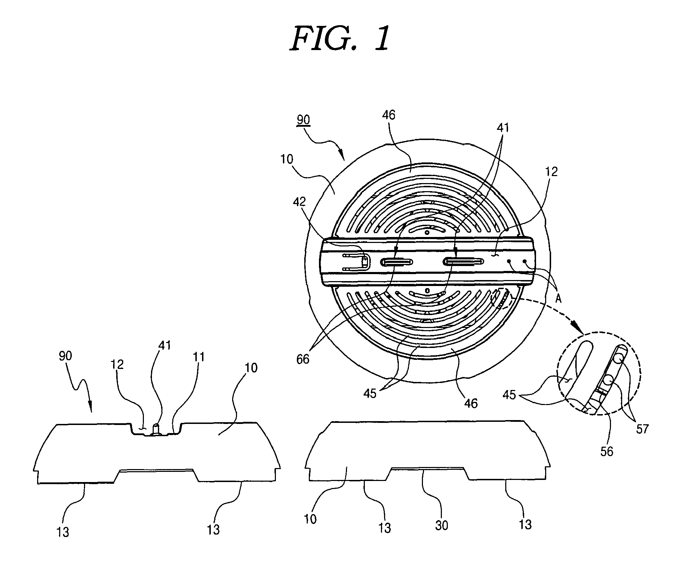

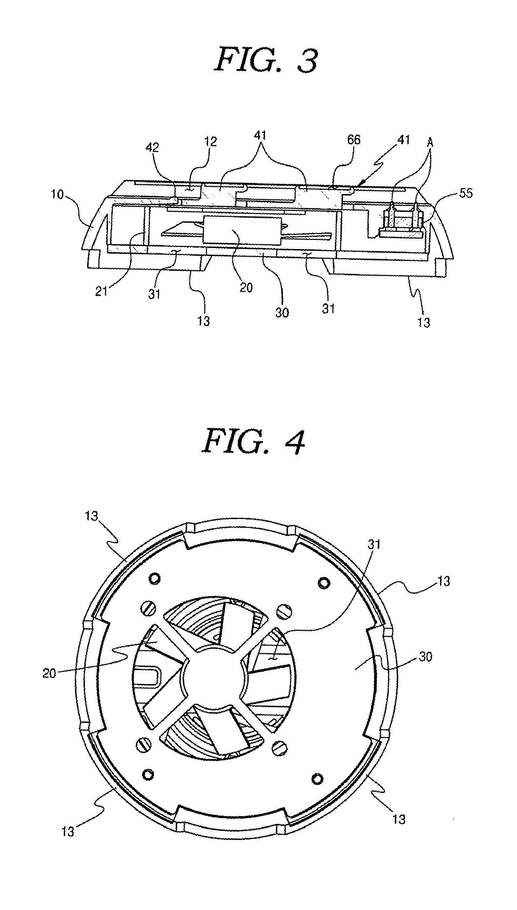

Hereinafter, a supporter for a multimedia player according to the present invention will be described in detail with reference to FIGS. 1 to 6.

The supporter for a multimedia player according to the invention includes a housing 10 having a support groove 12 and a plurality of legs 13. The support groove 12 which is formed to extend in the side-to-side direction has a through-hole formed on the top surface thereof, through which air blows, and a step portion 11 formed in the central portion thereof. The plurality of legs 13 are formed in the lower end of the side surface of the housing 10. Further, the housing 10 has a coupling structure for coupling a multimedia player 100, the coupling structure being provided in the upper end of the support groove 12.

Further, the supporter includes a fan 20 packed by a fan housing 21 coupled to the center of the housing 10 and a bottom plate 30 which is screwed to the housing 10 at the lower end of the fan 20 and has a plurality of suction holes 31 formed therein. As the air is introduced by the rotation of the fan 20 and is then discharged from the through-hole, the temperature of the multimedia player 100 coupled to the supporter 90 decreases.

That is, the supporter 90 for the multimedia player 100 prevents the degradation of image quality of the multimedia player 100, which may occur when the temperature of the multimedia player 100 increases, and enhances the durability of the multimedia player 100.

The multimedia player 100 can reproduce a variety of high-quality multimedia images such as HD broadcasting, HD video, HD DVD, and blue-ray images. That is, the multimedia player 100 having a body with a small volume receives operation power through a USB port or power terminal and reproduces moving images in a state where it is connected to a PC monitor or TV.

The multimedia player can reproduce moving image files stored in a hard disk or external disk or can reproduce the files copied into a hard disk embedded in the multimedia player. Further, the multimedia player can be connected to a PC, installed at a long distance from the multimedia player, through the Internet so as to reproduce moving images stored in the PC. In addition, the multimedia player can reproduce music files as well as moving images.

The multimedia player views HD broadcasting or a variety of high-quality multimedia contents on a TV set nearby disposed. Therefore, when the multimedia player has a high-performance moving image reproduction function while maintaining a main body with a small volume, the multimedia player can have competitive power.

Meanwhile, the moving-image reproduction process accompanies high-speed processing. Therefore, during the moving-image reproduction process, heat is generated inside the multimedia player. The supporter 90 according to the invention not only supports the multimedia player, but also cools down the heat generated from the multimedia player. In particular, as the fan 20 is installed in the supporter 90, the size of the multimedia player can be minimized.

As shown in the drawings, the supporter 90 is formed in a circular shape, but may be formed in a rectangular or polygonal shape. The supporter 90 has the support groove 12 formed in the upper end thereof, into which the lower end of the multimedia player 100 is inserted. Further, the step portion 11 is formed on the inner circumferential surface of the support groove 12 so as to slightly project, and the coupling structure is formed so as to project upward. The multimedia player can be attached to and detached from the supporter 90 through the coupling structure.

The fan 20 formed inside the housing 10 is rotated by electric power, and the shape of the fan 20 is not limited specifically. The bottom plate 30 supporting the fan 20 from the lower side is coupled to the housing 10 through a screw such that the coupling is reliably achieved. The multimedia player 100 constructed in such a manner is coupled to the housing 10 of the supporter 90 through the coupling structure.

To cool down the heat generated from the multimedia player 100, the fan 20 is rotated. In this embodiment, a temperature sensor may be used to check the temperature of the multimedia player 100 such that the fan 20 can be automatically operated. Alternatively, the fan 20 may be configured so as to be operated as soon as power is supplied.

When the fan 20 is operated in such a manner, the fan 20 is rotated. Simultaneously, the fan 20 sucks a large amount of air through the suction holes 31 formed in the bottom plate 30 and then discharges the air upward. Then, the air blows through the through-hole formed above the fan 20, that is, in the upper portion of the housing 10, thereby lowering the temperature of the multimedia player 100 coupled to the housing 10. At this time, the through-hole is not limited thereto. That is, a plurality of holes may be formed in the housing 10, or a large through-hole may be formed in either end of the support groove 12.

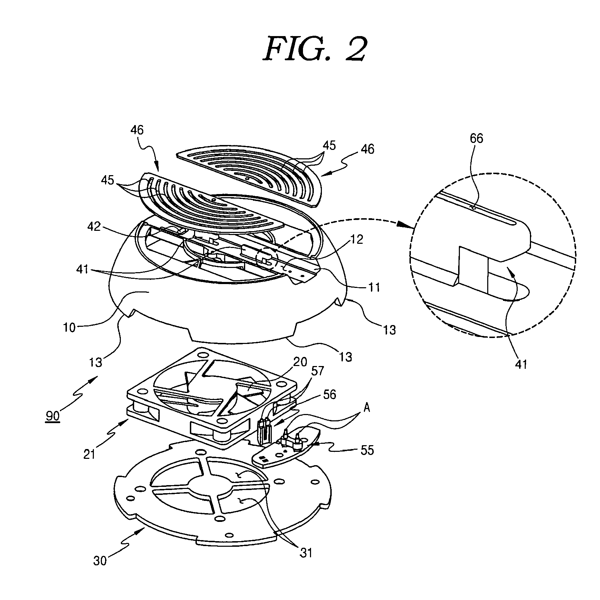

The coupling structure through which the multimedia player 100 and the supporter 90 are coupled to each other will be described in detail with reference to FIGS. 1 and 2. The coupling structure includes a pair of locking projections 41 which are formed in an L shape so as to be coupled to coupling holes of the multimedia player 100 in a sliding manner and have an elongated locking groove 66 formed thereon. That is, the multimedia player 100 has the separate coupling holes formed in the lower end thereof, the coupling holes corresponding to the locking projections 41.

Therefore, as the lower end of the multimedia player 100 is closely attached to the support groove 12 of the housing 10 and is pressed so as to be slid in the lateral direction, the locking projections 41 are inserted into the coupling holes such that the multimedia player 100 is reliably coupled to the housing 10.

As described above, the locking groove 66 is formed on each of the locking projections 41. The locking groove 66 serves as a space into which a separate projection (not shown) formed in each of the coupling holes (not shown) of the multimedia player 100 can be inserted. Therefore, when the multimedia player 100 is coupled to the supporter 90, the multimedia player 100 cannot be easily detached as long as an unintended force is not applied. Therefore, the coupling is stably and reliably achieved.

The coupling structure further includes a stopper projection 42 formed on one side of the top surface of the support groove 12, the stopper projection 42 springing out due to an elastic force. The one-touch coupling between the multimedia player 100 and the supporter 90 can be checked through the stopper projection 42.

That is, as the stopper projection 42 is formed in one side of the support groove 12, the multimedia player 100 is stably coupled, and the supporter 90 and the lower end of the multimedia player 100 are prevented from being damaged by an excessive pressing force.

When the multimedia player 100 is coupled to the housing 10 of the supporter 90 in a sliding manner, the stopper projection 42 is moved downward in a direction against the elastic force thereof. When the multimedia player 100 is fixed at an accurate position, the stopper projection 43 springs out and is received in a groove which is provided on the lower end of the multimedia player 100. At this time, since a user can feel a click feeling, the user does not need to apply a pressing force any more. That is, the stopper projection 42 serves as means which can achieve the stable coupling between the multimedia player 100 and the supporter 90 and through which the coupling can be checked.

As shown in FIGS. 1 and 2, ventilation plates 46 having a plurality of ventilation holes 45 formed therein are coupled to the top surface of the housing 10.

In this case, the ventilation plates 46 can be coupled to the housing 10 through a screw or adhesive. In FIGS. 1 and 2, the ventilation holes 45 are formed in an elongated and curved shape, but are not limited thereto. That is, the ventilation plates 46 may have a plurality of circular or polygonal holes formed therein, and the diameter of the holes may be changed depending on a situation.

Further, the fan 20 within the fan housing 21 may directly receive power from a power supply for operating the multimedia player 100, or may receive power through a separate outlet or USB port.

In the former, an outlet or USB port for supplying power is necessary so as to operate the multimedia player 100. Therefore, power supplied to the multimedia player 100 through the outlet or USB port is directly delivered to the supporter 90 so as to operate the fan 20.

Since the fan 20 is operated by a motor using power, the power is positively necessary for the fan 20. Therefore, the power supplied to the multimedia player 100 inserted into the upper end of the supporter 90 is used to operate the fan 20. The supporter 90 may include other electronic components such as a sensor and a stabilizer, in addition to the fan 20. Therefore, the power supplied to the multimedia player 100 is used to operate the electronic components.

In the latter, a separate outlet or USB port through which power can be supplied to the supporter 90 is provided, in addition the outlet or USB port through which power is supplied to the multimedia player 100.

FIG. 2 shows an example configured according to the latter. That is, a power connection terminal block 55 having positive (+) and negative (-) contacts A is coupled to the housing 10 such that the positive and negative contacts A project from the top surface of the support groove 12. Through the power connection terminal block 55, the power delivered from the multimedia player 100 is supplied to the fan 20.

That is, the power connection terminal block 55 connected to the fan 20 is coupled to a predetermined portion of the housing 10 such that the positive and negative contacts A formed on the terminal block 55 project to the outside of the housing 10.

Therefore, when the multimedia player 100 is inserted and coupled into the support groove 12 of the supporter 90, the power-line contact of the multimedia player 100 is electrically connected to the contacts A such that the power can be supplied. The power supplied in such a manner can be utilized as power for rotating the fan 20 inside the housing 10.

Preferably, the coupling structure between the multimedia player 100 and the supporter 90 is improved in relation to the power connection terminal block 55.

That is, the coupling structure may be modified in such a manner that when the supporter 90 and the multimedia player 100 are coupled to each other, the polarity of the contact of the supporter 90 is prevented from mismatching the polarity of the power supply terminal of the multimedia player 100. For this, the lengths of the L-shaped locking projections 41 provided on the top surface of the support groove 12 may be set to be different from each other, or the locking projections 41 may be formed to have a different orientation. Then, it is possible to prevent the multimedia player 100 from being coupled in the reverse direction to the preset direction. In this case, the coupling holes of the multimedia player 100 should be provided in accordance with the construction of the locking projections 41.

Meanwhile, as a light emitting diode (LED) 57 is turned on and off, it is possible to check whether the fan 20 is normally operated or not, through a separate lens 56 connected to the power supply. That is, the lens 56 is coupled in such a manner that the LED 45 can be seen through the through-hole formed on the housing 10 or the ventilation holes 45, as shown in FIG. 1.

For example, when abnormalities occur in the fan 20, the LED 57 emits red light. When the fan 20 is normally operated, the LED 57 emits blue light. The color of the light emitted from the LED 57 or the shape of the LED 57 is not limited thereto. The important point is that the abnormalities occurring in the fan 20 can be checked through the LED 57.

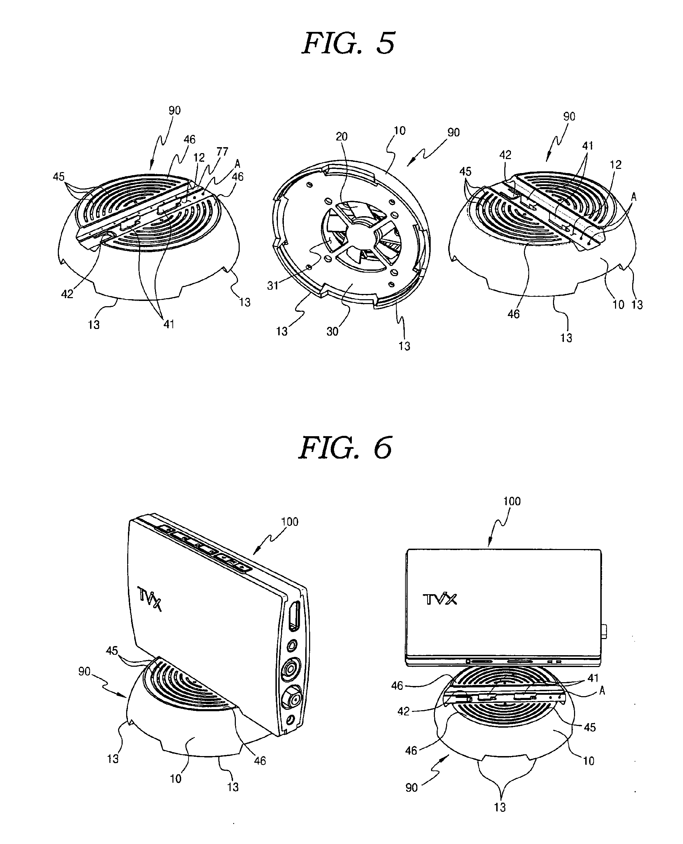

Meanwhile, it is preferable that a close packing 77 is attached to the upper or lower end of the step portion 11 of the support groove 12, as shown in FIG. 5. The close packing 77 serves to minimize friction when the multimedia player 100 is inserted into the supporter 90 in a sliding manner, thereby preventing the damage of the multimedia player 100.

According to the invention, since the fan is disposed in the supporter, the volume of the multimedia player can be reduced, which makes it possible to reduce to the size of the multimedia player.

Further, the fan disposed in the supporter cools down the heat generated from the multimedia player from outside, thereby enhancing the durability of the multimedia player.

## Claims

1. A supporter for a multimedia player, comprising:
a housing 10 including a support groove 12, a plurality of legs 13 and a coupling structure for coupling the housing with the multimedia player 100, wherein the support groove 12 has a through-hole on the top surface of the housing 10 through which air blows and further has a step portion 11 formed in the central portion of the housing 10, wherein the plurality of legs 13 is formed in the lower end of the side surface of the housing 10, and wherein the coupling structure is formed in the upper end of the support groove 12 extending in the side-to-side direction;
a fan 20 being packed by a fan housing 21 which is coupled to the center of the housing 10; and
a bottom plate 30 having a plurality of suction holes 31 and being coupled to the housing 10 at the lower end of the fan 20;
wherein the air is introduced by rotation of the fan 20 and is then discharged through the through-hole, thereby lowering the temperature of the multimedia player 100 which is coupled to the supporter 90.

2. The supporter according to Claim 1, wherein the coupling structure includes at least one L-shaped locking projections 41 so as to be coupled by sliding to coupling holes of the multimedia player 100, and wherein the locking projections 41 have an elongated locking groove 66 formed thereon.

3. The supporter according to Claim 2, wherein the coupling structure includes a stopper projection 42 which is formed in one side of the top surface of the support groove 12 and springs out due to an elastic force.

4. The supporter according to Claims 2 or 3, wherein the through-hole provided on the top surface of the housing 10 is formed so that at least one ventilation plates 46 having a plurality of elongated and curved ventilation holes 45 are coupled to the housing 10.

5. The supporter according to Claim 4, further comprising:
a power connection terminal block 55 having positive and negative contacts, wherein the power connection terminal block 55 is coupled to an internal portion of the housing 10 such that the positive and negative contacts project from the top surface of the support groove 12, thereby the power from the multimedia player 100 being supplied to the power connection terminal block 55.

6. The supporter according to Claim 5, wherein a close packing 77 is attached to the upper or lower end of the step portion 11 of the support groove 12.
